(19)

Europäisches
Patentamt
European
Patent Office
Office européen
des brevets

(11) **EP 3 855 120 A1**

(12) **EUROPEAN PATENT APPLICATION**

(43) Date of publication:
28.07.2021 Bulletin 2021/30

(21) Application number: 20153315.5

(22) Date of filing: 23.01.2020

(51) Int Cl.:
*G01C 21/20* (2006.01)          *B60W 30/095* (2012.01)
*B60W 50/00* (2006.01)          *B60W 60/00* (2020.01)
*G05D 1/02* (2020.01)          *G08G 1/16* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Robert Bosch GmbH**
**70442 Stuttgart (DE)**

(72) Inventors:
• **Velkey, Geza**
**2660 Ipolyszog (HU)**
• **Kis, Kornel Istvan**
**8300 Tapolca (HU)**
• **Korosi-Szabo, Peter**
**1119 Budapest (HU)**

Remarks:
Amended claims in accordance with Rule 137(2) EPC.

(54) **METHOD FOR LONG-TERM TRAJECTORY PREDICTION OF TRAFFIC PARTICIPANTS**

(57)    Method for long-term trajectory prediction for a prediction traffic participant of a plurality of traffic participants, wherein the traffic participants are an ego-vehicle or dynamic objects around the ego-vehicle, the method comprising the steps:
receiving environment data (E) from the ego-vehicle relating to the environment around the ego-vehicle;
receiving previous public state data (P[t-1]) of the plurality of traffic participants relating to different states of the plurality of traffic participants in a previous time step;
determining environment features (F) based on the environment data (E) by an environmental model (ME) relating to the environment of the prediction traffic partici-
pant;
determining dynamic features (D) based on the previous public state data (P[t-1]) by a dynamic interpreter model (MD) relating to modelled interactions between the plurality traffic participants;
predicting dynamic interactions (I) of the prediction traffic participant between the prediction traffic participant and the plurality of traffic participants based on the environmental features (F) and the dynamic feature (D) by an interaction model (MI); and
determining a trajectory (T) of the prediction traffic participant based on the predicted dynamic interactions (I) and the determined environment features (F).

**Fig. 1**

**Description**

The present invention relates to a method for long-term trajectory prediction of traffic participants, as well as a control method, a control unit, a computer program and a computer readable data carrier.

Prior art

Accurate long-term trajectory prediction into the future given the past and the present is an extremely challenging research problem in general. In the field of vehicle automation, behaviour prediction/trajectory prediction today mainly consists of modelling the very near future, usually the next 1 second. In this very short time horizon, effects of car and environment physics dominate the behaviour. Usually, a simple linear assumption, otherwise known as constant velocity model is enough to predict the future with acceptable accuracy. Most systems use different types of Kalman filter based solutions for this purpose. As the time horizon is increased to satisfy the requirements of systems which plan and act on a longer horizon, these simple models are incapable of providing accurate future predictions for bigger time horizons.

Especially in the automotive sector or robotics sector, current automated, for example Level 2 and Level 3, robots or vehicles rely on some kind of a model of the environment around the car. This is generally known as environment hypothesis. As the level of automation rises, it becomes increasingly difficult to rely on only the knowledge of the present state and the very near future of the environment. Most problems, which arise in cars with higher automation, for example Level 4 and Level 5, often revolve around the semantic understanding of the environment. Predicting the future states of the environment is a key factor during semantic understanding. If more than just modelling the physics for very short time periods is desired, current models fall short of predicting for longer time horizons, where it is driver or system intent, not just physics, what dominates the trajectory patterns.

Thus, there is need for a new approach and new models where driver intent and car-environment interactions can be explicitly modelled, and integrated into a flexible, data-driven, large-scale approach.

Disclosure of the invention

According to an aspect of the invention, a method for long-term trajectory prediction for a prediction traffic participant of a plurality of traffic participants is provided, wherein the traffic participants are an ego-vehicle or dynamic objects around the ego-vehicle, the method comprising the following steps. Receiving environment data from the ego-vehicle relating to the environment around the ego-vehicle. Receiving previous public state data of the plurality of traffic participants relating to different states of the plurality of traffic participants in a previous time step. Determining environment features based on the environment data by an environmental model relating to the environment of the prediction traffic participant. Determining dynamic features based on the previous public state data by a dynamic interpreter model relating to modelled interactions between the plurality of traffic participants. Predicting dynamic interactions of the prediction traffic participant between the prediction traffic participant and the plurality of traffic participants based on the environmental features and the dynamic feature by an interaction model. Determining a trajectory of the prediction traffic participant based on the predicted dynamic interactions and the determined environment features.

Preferably, the prediction traffic participant is the traffic participant for which a trajectory should be determined or in other word predicted.

The term "state", as used herein, refers to a numerical manifestation of a learned hidden vector, which represents all the information of the object known at the moment.

The term "environment data", as used herein, comprises a representation of objects surrounding the ego-vehicle. Preferably, the environment data comprises a joint representation of static and dynamic objects, wherein the static objects comprise road characteristics and obstacles and wherein the dynamic objects comprise pedestrians and cars.

Preferably, the dynamic interpreter model comprises a social pooling interpreter, a bidirectional Long Short Term Memory, LSTM, dynamic interpreter, a Point-Net dynamic interpreter, an attention based dynamic interpreter or a traffic rule based dynamic interpreter.

The social pooling interpreter uses the principle of locality. In other words, a traffic participant is mostly affected by its close surrounding. Preferably, a grid cell of fixed predetermined size is being built around the ego-vehicle. In each time step the public states of the dynamic objects moving in the same grid cell are used and shared between the dynamic objects and the eco-vehicle. This way, the dynamic objects in the same grid cell can communicate and learn to share information near them, in other words in their neighbourhood. Thus, if the assumption of being mostly affected by the close surrounding of the traffic participant is heavily violated, the social pooling interpreter performs relatively poorly. However, if the assumption is true, the social pooling interpreter is a relatively good model of traffic participant interaction.

The Bidirectional LSTM dynamic interpreter, or Bidirectional Long Short Term Memory dynamic interpreter, performs no hard selection compared to the social pooling interpreter. Instead, the Bidirectional LSTM dynamic interpreter processes all public states and thus all dynamic objects based on a Bidirectional LSTM model. Compared to the social pooling interpreter, the Bidirectional LSTM dynamic interpreter ensures a more symmetric approach. Since there for many dynamic objects the information about the first couple objects may be overwritten by the later processed objects due to the big distance some information need to travel in the network.

The PointNet dynamic interpreter is able to provide a true mapping of dynamic objects without an artificially induced order. Compared to the social pooling dynamic interpreter and the Bidirectional LSTM dynamic interpreter, which introduce some sort of an order through which the dynamic objects are processed in the network, this is not the case in the PointNet dynamic interpreter. The introduced order may be considered harmful if the dynamic objects are considered a set instead of a list of objects.

The attention based dynamic interpreter directly exploits properties of the traffic scenario. If the network understands the traffic scenario a priori, either from a lookup from a traffic scenario catalogue or some data-driven method, then it can be chosen which dynamic agents are of more interest from the ego perspective.

The Traffic rule dynamic interpreter also benefits from understanding the traffic scenario. Compared to the attention based dynamic interpreter, the Traffic rule dynamic interpreter uses its perception or HD maps to notify the network of traffic rules in the specific traffic scenario. This additional information is used to choose the dynamic agents.

Preferably, determining the environment features comprises a fusion of different sensors of the ego-vehicle.

Since the dynamic interpreter model predicts dynamic interactions for all traffic participants, partial observability may be problematic. The environment data is only received from the ego-vehicle, thus it cannot be guaranteed that useful environment data is available for every traffic participant. This is mainly due to 3D occlusion effects. Thus, sensors which can not only see the closest object but see further away are preferably incorporated, for example radar sensor in addition to visual sensors, and fused. Additionally, more preferably, HD maps are used for the extraction of environment data.

In other words, explicit modelling of dynamic interactions between traffic participants is provided. Additionally, efficient extracting of the environments of all dynamic objects of interest is provided. Thus, a model is provided that adopts a full data-driven approach where the interaction model and the intent prediction is fully learned from the environment through methods from large-scale deep learning.

In consequence, the interaction model also is able to learn the concept of "unknown area", if not enough environmental data can be extracted for one or more traffic participants.

Preferably, the internal representation is robust, while compact and efficient for neural networks to process as inputs.

Thus, accurate long-term prediction of objects around an ego car is provided.

A relationship between the prediction and the input of the interaction model can be expressed by the following equation 1:

$$\text{Equation 1: Prediction} = P(D|E,W)$$

E represents past and current states of the environment, or in other words the surrounding traffic participants.

W represents adjustable parameters for the interaction model.

D represents a distribution from which the predictions are sampled. In other words, the distribution reflects a variety of possible future actions of the traffic participants.

Equation 1 models a probabilistic view of the given problem. In other words, predictions arise as certain parametric distributions are sampled. From the distributions, trajectories are calculated from the samples via means of successive sampling of the distributions and re-feeding/re-parametrization, wherein refeeding means the act of looping back the current prediction to induce the next steps of the prediction of the interaction model.

Thus, a flexible setup is provided where the number of samples generated roughly scales with available hardware capabilities as well as a prediction quality.

For the actions, in the most basic setup, a two-dimensional parametric Gaussian distribution is predicted. This allows easy interpretation, however, in real world scenarios it may be necessary to predict more complex distributions since the true distribution is also likely to be a multi-modal distribution.

Preferably, model instances run separately and concurrently on all traffic participants around the ego vehicle, the ego vehicle itself is also included. These instances share weights - a.k.a. model parameters - but have different inputs, and therefore will have different outputs and states. The whole computation preferably still runs on the ego-vehicle, the model thus internally runs the abovementioned steps for all dynamic objects. Since via refeeding, successive predictions can be generated and again refed into the network, it is possible to generate arbitrarily long predictions of objects, given the full current knowledge up until the present. This knowledge is accumulated in the state of each dynamic object based on past and current time steps, and a-priori learned information.

The implementation heavily relies on dynamic computational graphs. Dynamic computational graphs allow the training and the prediction of an arbitrary number of objects at the same time. When the system is running, it continuously registers objects that come near the car, and deletes them as soon as they go out of scope (out of sensor range). As soon as the second measurement arrives from a new object, predictions start to generate until the object moves out of scope. Based on the available computational resources, it is possible to precisely control how refined the prediction will be. This tuning is mainly implemented through the control of the quantitative parameters of the sampling and the time horizon. The model, along with its components have several other tuneable parameters, with which it is possible to fit the model onto hardware with varying computational capabilities.

Thus, an improved method for long-term trajectory prediction of traffic participants is provided.

In a preferred embodiment, the method comprises the following steps. Receiving previous state data of the prediction traffic participant relating to a state of the prediction traffic participant in a previous time step. Receiving previous action data of the prediction traffic participant relating to an action of the prediction traffic participant in a previous time step. Determining the trajectory of the prediction traffic participant based on the predicted dynamic interactions, the determined environment features, the previous state data and the previous action data.

Thus, an improved method for long-term trajectory prediction of traffic participants is provided.

In a preferred embodiment the method comprises the following steps. Determining current public state data of the traffic participants relating to different states of the traffic participants in a current time step. Determining current state data of the prediction traffic participant relating to a state of the prediction traffic participant in a current time step. Determining current action data of the prediction traffic participant relating to an action of the prediction traffic participant in a current time step. The current public state data, the current state data and the current action data is used as input for a subsequent time step.

Preferably, the previous action data and previous state data have the same properties as the current action data and the current state data, respectively.

Thus, the prediction of the trajectory can be increased for more time steps.

Thus, an improved method for long-term trajectory prediction of traffic participants is provided.

In a preferred embodiment, the dynamic interactions are predicted separately and concurrently for each traffic participants.

Thus, an improved method for long-term trajectory prediction of traffic participants is provided.

In a preferred embodiment, the environment features comprise an internal representation of the environment data.

Thus, an improved method for long-term trajectory prediction of traffic participants is provided.

In a preferred embodiment, the interaction model comprises a temporal recurrent neural network cell, which during training, periodically receives the environment data and determines the internal representation of the environment data based on the received environment data.

The temporal recurrent neural network cell is preferably configured for predicting an action of surrounding traffic participants.

Thus, during inference, a new dynamic interaction is predicted for longer time horizons for all objects around the ego-vehicle.

Thus, an improved method for long-term trajectory prediction of traffic participants is provided.

In a preferred embodiment, the interaction model supports branching, wherein multiple predictions are determined and evaluated based on multiple scenarios concurrently.

Thus, an improved method for long-term trajectory prediction of traffic participants is provided.

In a preferred embodiment, the method comprises the following steps. Determining at least one gate based on the environment features, the dynamic features, the previous action data and/or the previous state data by a gating model. The at least one gate filters the respective environment features, dynamic features, previous action data and/or previous state data for being relevant in a current traffic scenario of the prediction traffic participant.

Preferably, the gating model adds measurements or measurement rates of how new information about environment data is added to existing information Thus, the gating model is able to learn what is important in the current traffic scenario. Thus, an efficient automatic feature extractor functionality is implicitly implemented by the gating model.

According to an aspect of the invention, a control unit is configured for executing a method, as described herein.

According to an aspect of the invention, a control method of an at least partly autonomous robot, comprising the following steps. Receiving sensor data of the at least partly autonomous robot. Executing a method for long-term trajectory prediction for a prediction traffic participant of a plurality of traffic participants, as described herein, thereby determining a trajectory for the prediction traffic participant. Controlling the at least partly autonomous robot dependent on the determined trajectory for the prediction traffic participant.

Preferably, the sensor data relate to objects in the environment of the at least partly autonomous robot.

Preferably, the sensor data comprises lidar data, radar data, thermal data, ultrasonic data and/or image data, in particular camera data.

Preferably, the at least partly autonomous robot comprises an at least partly autonomous vehicle. Alternatively, the at least partly autonomous robot may be any other mobile robot, for example those moving by flying, swimming, diving or walking. In an example, the at least partly autonomous robot may be an at least partly autonomous lawn mower or an at least partly autonomous cleaning robot.

According to an aspect of the invention, a computer program comprises instructions which, when the program is executed by a computer, cause the computer to carry out the method, as described herein.

According to an aspect of the invention, a computer-readable data carrier is provided, having stored there on the computer program, as described herein.

The subject matter of the invention will be explained in more detail in the following text with reference to preferred exemplary embodiments, which are illustrated in the attached drawings, in which:

Fig. 1 shows a schematic view of a system for long-term trajectory prediction of traffic participants;

Fig. 2 shows a schematic view of a Social Pooling dynamic interpreter;

Fig. 3 shows a schematic view of a Bidirectional LSTM interpreter; and

Fig. 4 shows a schematic view of a method for long-term trajectory prediction of traffic participants.

The reference symbols used in the drawings, and their meanings, are listed in summary form in the list of reference symbols. In principle, identical parts are provided with the same reference symbols in the figures.

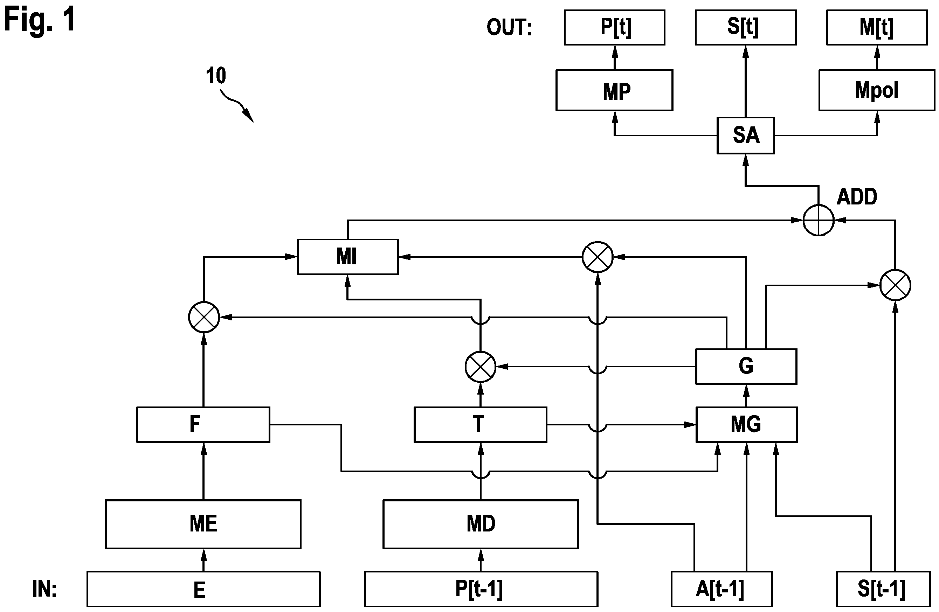

Fig. 1 shows a schematic view of a system 10 for long-term trajectory prediction of traffic participants. The used notation is generally used in deep learning scientific literature. The system uses four inputs, environment data E, batched public states P[t-1], previous action data A[t-1] and previous state data S[t-1].

The environment data E are in form of an environment vector. This is preferably a circular representation of the environment around the ego-vehicle. A granularity of the environment data E is arbitrary, however 360° around the ego-vehicle is preferred to relate to the environment in all directions. The environment data E comprises all static and dynamic objects around the ego-vehicle.

The previous public state data P[t-1], also referred to as batched public states, relate to the different states of nearby objects, in particular traffic participants, in a previous time step. The previous public state data P[t-1] comprises learned vectors of nearby objects grouped together. Optionally, additional public states are manually added to the previous public state data P[t-1]. In other words those handcrafted features open up the possibility to add custom features which might improve the prediction of the upcoming interaction model MI, which the previous public sate data P[t-1] is fed to. For example, the custom features comprise velocity, relative velocity to other agents, relative distance and acceleration.

The previous action data A[t-1] relate to actions of the ego vehicle or a specific nearby object, in particular a specific traffic participant, in a previous time step for which new action data A[t] should be predicted. The previous action data A[t-1] are samples from a multi-dimensional parametric distribution representing the action. For example, two-dimensional Gaussian distributions are predicted by the interaction model MI, in particular with parameters mean and covariance matrix. Preferably, any parametric distribution using direct learning or means of normalizing flows are used. Normalizing flows essentially implement a series of invertible, volume -tracking transformations of probability distributions, and can be used to transform the posterior distribution.

The previous state data S[t-1] relate to states of the ego vehicle or a specific nearby object, in particular a specific traffic participant, in a previous time step for which new state data S[t] should be predicted. A state at a given point in time preferably refers to a numerical manifestation of a learned hidden vector, which represents all information of the object known at the moment.

The environment data E, the previous public state data P[t-1], the previous action data A[t-1], and the previous state data S[t-1] are input tensors, wherein a tensor defines a multidimensional array.

The environment data E is provided to an environment model ME, also referred to as environment interpreter. The environment model ME comprises a neural network, which is configured for interpreting the environment data E. The environment model ME extracts environment features F for the specific traffic participant for which new data should be predicted. The basis of the environment data E are generally sensors of the ego vehicle. The environment features F thus is the part of the environment data E that is relevant for the specific traffic participant for which new data should be predicted.

The previous public state data P[t-1] is provided to an interaction model MI. The interaction model MI predicts dynamic interactions I for the traffic participants between the respective traffic participants. The interaction model MI comprises a neural network.

The system 10 comprises a gating model MG. The gating model MG is provided with previous action data A[t-1] and previous state data S[t-1]. The gating model MG determines which dynamic object around the ego-vehicle is a relevant dynamic object based on a measurement value or a measurement rate of the environment data. Thus, the interaction model MI is only provided with necessary information for the prediction traffic participant.

The interaction model MI then determines dynamic interactions I of the prediction traffic participant between the prediction traffic participant and the plurality of traffic participants based on the environmental features F and the dynamic feature D.

The dynamic interactions I and the gated previous state data S[t-1] is provided to an adder ADD, which determines a state array SA, being a hidden tensor. Based on the state array, SA, a public state model MP determines current public state data P[t]. Based on the state array SA current state data S[t] is determined. Based on the state array SA, a policy model Mpol determines current action data A[t].

The environment model ME, the dynamic interpreter model MD, the gating model MG, the public state model MP and the policy model Mpol are neural networks.

The environmental features F, the dynamic features D, the gates G (for easier visibility also marked as the crossed circles) and the state array SA are hidden tensors, which are defined by being multidimensional arrays.

Generally, the shown system comprises recurrence, which is not shown in Fig. 1. The new state data S[t], the new action data A[t] and the new public state P[t] is in a next time step part of the previous state data S[t-1], previous action data A[t-1] and previous public state data P[t-1].

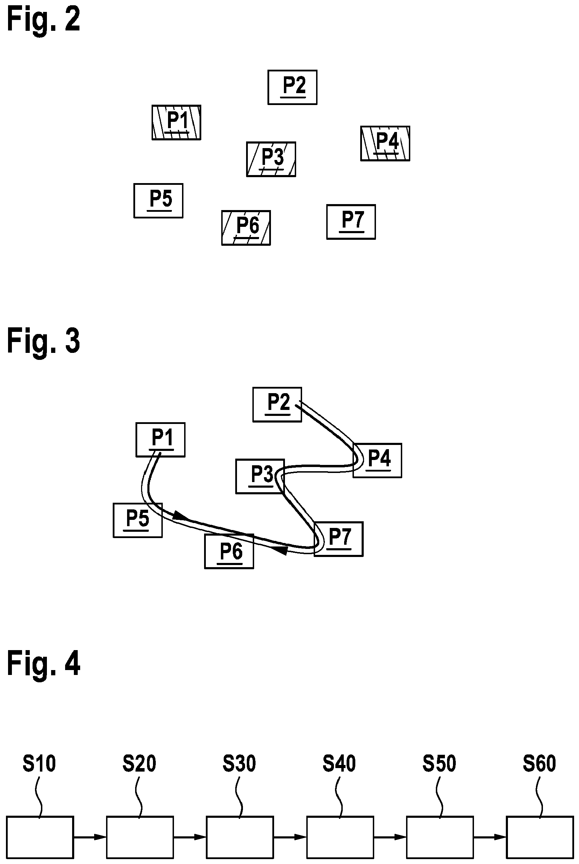

Fig. 2 shows a schematic view of a Social Pooling dynamic interpreter. The social pooling interpreter uses the principle of locality. In other words, a traffic participant is mostly affected by its close surrounding. Preferably, a grid cell of fixed predetermined size is being built around the ego-vehicle. In each time step, the public states of the dynamic objects moving in the same grid cell are used and shared between the dynamic objects and the ego-vehicle. This way, the dynamic objects in the same grid cell can communicate and learn to share information near them, in other words in their neighbourhood. Thus, if the assumption of being mostly affected by the close surrounding of the traffic participant is heavily violated, the social pooling interpreter performs relatively poorly. However, if the assumption is true, the social pooling interpreter is a relatively good model of traffic participant interaction. Fig. 2 illustrates the concept, where objects having the same filling represent spatial proximity.

Fig. 3 shows a schematic view of a Bidirectional LSTM interpreter. The Bidirectional LSTM dynamic interpreter, or Bidirectional Long Short Term Memory dynamic interpreter, performs no hard selection compared to the social pooling interpreter. Instead, the Bidirectional LSTM dynamic interpreter processes all public states and thus all dynamic objects based on a Bidirectional LSTM model. Compared to the social pooling interpreter, the Bidirectional LSTM dynamic interpreter ensures a more symmetric approach. Since there for many dynamic objects the information about the first couple objects may be overwritten by the later processed objects due to the big distance some information need to travel in the network. Using the graph notation, Bidirectional LSTM refers to as performing two Hamiltonian walks, back and forth, on the graph, where the start and the end nodes are random for each time step.

In other words, a public state is essentially a vector of size N, N being a tuneable parameter, The interaction module outputs a vector of size K, K being a tuneable parameter, representing the dynamic features in that time step. Preferably, another dimension is the number of dynamic objects, which completes the data structure which is now 3-dimensional.

Fig. 4 shows a schematic view of the method for long-term trajectory prediction for a prediction traffic participant of a plurality of traffic participants, wherein the traffic participants are an ego-vehicle or dynamic objects around the ego-vehicle, the method comprising the following steps. In a first step S10, environment data E is received from the ego-vehicle relating to the environment around the ego-vehicle. In a second step S20, previous public state data P[t-1] is received of the plurality of traffic participants relating to different states of the plurality of traffic participants in a previous time step. In a third step S30, environment features F are determined based on the environment data E by an environmental model ME relating to the environment of the prediction traffic participant. In a fourth step S40, dynamic features D are determined based on the previous public state data P[t-1] by a dynamic interpreter model MD relating to modelled interactions between the plurality of traffic participants. In a fifth step S50, dynamic interactions I of the prediction traffic participant are predicted between the prediction traffic participant and the plurality of traffic participants based on the environmental features F and the dynamic feature D by an interaction model MI. In a sixth step S60, a trajectory T of the prediction traffic participant is determined based on the predicted dynamic interactions I and the determined environment features F.

**Claims**

1. Method for long-term trajectory prediction for a prediction traffic participant of a plurality of traffic participants, wherein the traffic participants are an ego-vehicle or dynamic objects around the ego-vehicle, the method comprising the steps:

   receiving (S10) environment data (E) from the ego-vehicle relating to the environment around the ego-vehicle;
   receiving (S20) previous public state data (P[t-1]) of the plurality of traffic participants relating to different states of the plurality of traffic participants in a previous time step;
   determining (S30) environment features (F) based on the environment data (E) by an environmental model (ME) relating to the environment of the prediction traffic participant;
   determining (S40) dynamic features (D) based on the previous public state data (P[t-1]) by a dynamic interpreter model (MD) relating to modelled interactions between the plurality traffic participants;
   predicting (S50) dynamic interactions (I) of the prediction traffic participant between the prediction traffic participant and the plurality of traffic participants based on the environmental features (F) and the dynamic feature (D) by an interaction model (MI); and
   determining (S60) a trajectory (T) of the prediction traffic participant based on the predicted dynamic interactions (I) and the determined environment features (F).

2. Method of claim 1, comprising the steps:

receiving previous state data (S[t-1]) of the prediction traffic participant relating to a state of the prediction traffic participant in a previous time step;
receiving previous action data (A[t-1]) of the prediction traffic participant relating to an action of the prediction traffic participant in a previous time step; and
determining the trajectory (T) of the prediction traffic participant based on the predicted dynamic interactions (I), the determined environment features (F), the previous state data (S[t-1]) and the previous action data (A[t-1]).

3. Method of any of the preceding claims, comprising the steps:

determining current public state data (P[t]) of the traffic participants relating to different states of the traffic participants in a current time step;
determining current state data (S[t]) of the prediction traffic participant relating to a state of the prediction traffic participant in a current time step; and
determining current action data (A[t]) of the prediction traffic participant relating to an action of the prediction traffic participant in a current time step; wherein
the current public state data (P[t]), the current state data (S[t]) and the current action data (A[t]) is used as input for a subsequent time step.

4. Method of any of the preceding claims, wherein the dynamic interactions (I) are predicted separately and concurrently for each traffic participants.

5. Method of any of the preceding claims, wherein the environment features (F) comprise an internal representation of the environment data (E).

6. Method of any of the preceding claims, wherein the interaction model (MI) comprises a temporal recurrent neural network cell, which during training, periodically receives the environment features (F) and determines the internal representation of the environment data based on the received environment data.

7. Method of any of the preceding claims, wherein the interaction model (MI) supports branching, wherein multiple predictions are determined and evaluated based on multiple scenarios concurrently.

8. Method of any of the preceding claims, comprising the steps:

determining at least one gate (G) based on the environment features (F), the dynamic features (D), the previous action data (A[t-1]) and/or the previous state data (S[t-1]) by a gating model (MG);
wherein the at least one gate (G) filters the respective environment features (F), dynamic features (D), previous action data (A[t-1]) and/or previous state data (S[t-1]) for being relevant in a current traffic scenario of the prediction traffic participant.

9. Control unit, configured for executing a method of any of claims 1 to 8.

10. Control method of an at least partly autonomous robot, comprising the steps:

receiving sensor data of the at least partly autonomous robot;
executing a method for long-term trajectory prediction for a prediction traffic participant of a plurality of traffic participants of any of the claims 1 to 8 thereby determining a trajectory for the prediction traffic participant; and
controlling the at least partly autonomous robot dependent on the determined trajectory for the prediction traffic participant.

11. Computer program, comprising instructions which, when the program is executed by a computer, cause the computer to carry out the method of any of claims 1 to 8.

12. Computer-readable data carrier, having stored there on the computer program, of claim 11.

Amended claims in accordance with Rule 137(2) EPC.

1. Method for long-term trajectory prediction for a prediction traffic participant of a plurality of traffic participants, wherein the traffic participants are an ego-vehicle or dynamic objects around the ego-vehicle, the method comprising the steps:

receiving (S10) environment data (E) from the ego-vehicle relating to the environment around the ego-vehicle;
receiving (S20) previous public state data (P[t-1]) of the plurality of traffic participants relating to different states of the plurality of traffic participants in a previous time step;
determining (S30) environment features (F) based on the environment data (E) by an environmental model (ME) relating to the environment of the prediction traffic participant;

wherein the environment features (F) comprise an internal representation of the environment data (E);

determining (S40) dynamic features (D) based on the previous public state data (P[t-1]) by a dynamic interpreter model (MD) relating to modelled interactions between the plurality of traffic participants;

predicting (S50) dynamic interactions (I) of the prediction traffic participant between the prediction traffic participant and the plurality of traffic participants based on the environmental features (F) and the dynamic feature (D) by an interaction model (MI); and

determining (S60) a trajectory (T) of the prediction traffic participant based on the predicted dynamic interactions (I) and the determined environment features (F);

wherein the dynamic interactions (I) are predicted separately and concurrently for each traffic participants.

2. Method of claim 1, comprising the steps:

receiving previous state data (S[t-1]) of the prediction traffic participant relating to a state of the prediction traffic participant in a previous time step;

receiving previous action data (A[t-1]) of the prediction traffic participant relating to an action of the prediction traffic participant in a previous time step; and

determining the trajectory (T) of the prediction traffic participant based on the predicted dynamic interactions (I), the determined environment features (F), the previous state data (S[t-1]) and the previous action data (A[t-1]).

3. Method of any of the preceding claims, comprising the steps:

determining current public state data (P[t]) of the traffic participants relating to different states of the traffic participants in a current time step;

determining current state data (S[t]) of the prediction traffic participant relating to a state of the prediction traffic participant in a current time step; and

determining current action data (A[t]) of the prediction traffic participant relating to an action of the prediction traffic participant in a current time step; wherein

the current public state data (P[t]), the current state data (S[t]) and the current action data (A[t]) is used as input for a subsequent time step.

4. Method of any of the preceding claims, wherein

the interaction model (MI) comprises a temporal recurrent neural network cell, which during training, periodically receives the environment features (F) and determines the internal representation of the environment data based on the received environment data.

5. Method of any of the preceding claims, wherein the interaction model (MI) supports branching, wherein multiple predictions are determined and evaluated based on multiple scenarios concurrently.

6. Method of any of the preceding claims, comprising the steps:

determining at least one gate (G) based on the environment features (F), the dynamic features (D), the previous action data (A[t-1]) and/or the previous state data (S[t-1]) by a gating model (MG);

wherein the at least one gate (G) filters the respective environment features (F), dynamic features (D), previous action data (A[t-1]) and/or previous state data (S[t-1]) for being relevant in a current traffic scenario of the prediction traffic participant.

7. Control unit, configured for executing a method of any of claims 1 to 6.

8. Control method of an at least partly autonomous robot, comprising the steps:

receiving sensor data of the at least partly autonomous robot;

executing a method for long-term trajectory prediction for a prediction traffic participant of a plurality of traffic participants of any of the claims 1 to 6 thereby determining a trajectory for the prediction traffic participant; and

controlling the at least partly autonomous robot dependent on the determined trajectory for the prediction traffic participant.

9. Computer program, comprising instructions which, when the program is executed by a computer, cause the computer to carry out the method of any of claims 1 to 6.

10. Computer-readable data carrier, having stored there on the computer program, of claim 9.

# Fig. 1

# Fig. 2

P2

P1

P3

P4

P5

P6

P7

# Fig. 3

P2

P1

P3

P4

P5

P7

P6

# Fig. 4

S10   S20   S30   S40   S50   S60

Europäisches
Patentamt
European
Patent Office
Office européen
des brevets

# EUROPEAN SEARCH REPORT

Application Number

EP 20 15 3315

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/367021 A1 (ZHAO YUE [US] ET AL) 5 December 2019 (2019-12-05) * paragraphs [0003], [0029] - [0054], [0244], [0313] * | 1-12 | INV. G01C21/20 B60W30/095 B60W50/00 B60W60/00 G05D1/02 G08G1/16 |
| A | DING WENCHAO ET AL: "Online Vehicle Trajectory Prediction using Policy Anticipation Network and optimization-based Context Reasoning", 2019 INTERNATIONAL CONFERENCE ON ROBOTICS AND AUTOMATION (ICRA), IEEE, 20 May 2019 (2019-05-20), pages 9610-9616, XP033593535, DOI: 10.1109/ICRA.2019.8793568 [retrieved on 2019-08-09] * section II and III * | 1-12 | |
| A | DEO NACHIKET ET AL: "Multi-Modal Trajectory Prediction of Surrounding Vehicles with Maneuver based LSTMs", 2018 IEEE INTELLIGENT VEHICLES SYMPOSIUM (IV), IEEE, 26 June 2018 (2018-06-26), pages 1179-1184, XP033423439, DOI: 10.1109/IVS.2018.8500493 [retrieved on 2018-10-18] * section IV, V * | 1-12 | TECHNICAL FIELDS SEARCHED (IPC) G01C G05D B60W G08G G06K |
| X | US 2019/152490 A1 (LAN TIAN [US] ET AL) 23 May 2019 (2019-05-23) * paragraphs [0023] - [0032] * | 1-12 | |

-/--

The present search report has been drawn up for all claims

| Place of search | Date of completion of the search | Examiner |
|---|---|---|
| The Hague | 29 July 2020 | Gagin, Thibaut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 20 15 3315

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MESSAOUD KAOUTHER ET AL: "Non-local Social Pooling for Vehicle Trajectory Prediction", 2019 IEEE INTELLIGENT VEHICLES SYMPOSIUM (IV), IEEE, 9 June 2019 (2019-06-09), pages 975-980, XP033605962, DOI: 10.1109/IVS.2019.8813829 [retrieved on 2019-08-26] * section II * | 1-12 | |

TECHNICAL FIELDS
SEARCHED        (IPC)

The present search report has been drawn up for all claims

| Place of search | Date of completion of the search | Examiner |
|---|---|---|
| The Hague | 29 July 2020 | Gagin, Thibaut |

EPO FORM 1503 03.82 (P04C01)

## ANNEX TO THE EUROPEAN SEARCH REPORT
## ON EUROPEAN PATENT APPLICATION NO.

EP 20 15 3315

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2020

| Patent document cited in search report | | Publication date | Patent family member(s) | | Publication date |
|---|---|---|---|---|---|
| US 2019367021 | A1 | 05-12-2019 | NONE | | |
| US 2019152490 | A1 | 23-05-2019 | US | 2019152490 A1 | 23-05-2019 |
| | | | US | 2020180648 A1 | 11-06-2020 |
| | | | WO | 2019104112 A1 | 31-05-2019 |

EPO FORM P0459

For more details about this annex : see Official Journal of the European Patent Office, No. 12/82